(19) **Europäisches Patentamt / European Patent Office / Office européen des brevets**

(11) **EP 2 053 751 A1**

(12) **EUROPEAN PATENT APPLICATION**
published in accordance with Art. 153(4) EPC

(43) Date of publication:
**29.04.2009 Bulletin 2009/18**

(51) Int Cl.:
***H03M 13/19*** (2006.01)

(21) Application number: **07791869.6**

(22) Date of filing: **02.08.2007**

(86) International application number:
**PCT/JP2007/065195**

(87) International publication number:
**WO 2008/016117 (07.02.2008 Gazette 2008/06)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **04.08.2006 JP 2006213722**

(71) Applicant: **Mitsubishi Electric Corporation Chiyoda-ku Tokyo 100-8310 (JP)**

(72) Inventors:
• **MATSUMOTO, Wataru**
**Chiyoda-ku**
**Tokyo 100-8310 (JP)**
• **SAKAI, Rui**
**Chiyoda-ku**
**Tokyo 100-8310 (JP)**
• **YOSHIDA, Hideo**
**Chiyoda-ku**
**Tokyo 100-8310 (JP)**

(74) Representative: **Pfenning, Meinig & Partner GbR Patent- und Rechtsanwälte Theresienhöhe 13 80339 München (DE)**

(54) **INSPECTION MATRIX GENERATION METHOD, ENCODING METHOD, COMMUNICATION DEVICE, COMMUNICATION SYSTEM, AND ENCODER**

(57) A check-matrix generating method includes a quasi-cyclic matrix generating step of generating a regular quasi-cyclic matrix in which cyclic permutation matrices are arranged in a row direction and a column direction and specific regularity is given to the cyclic permutation matrices; a mask-matrix generating step of generating a mask matrix capable of supporting a plurality of encoding rates, for making the regular quasi-cyclic matrix into irregular; a masking step of converting a specific cyclic permutation matrix in the regular quasi-cyclic matrix into a zero-matrix using a mask matrix corresponding to a specific encoding rate to generate an irregular masking quasi-cyclic matrix; and a check-matrix generating step of generating an irregular parity check matrix with an LDGM (low-density generation matrix) structure in which the masking quasi-cyclic matrix and a matrix in which the cyclic permutation matrices are arranged in a staircase manner are arranged in a predetermined location.

**FIG.2-1**

START

SET SIZE OF MASK MATRIX TO MULTIPLE OF EIGHT — S1

OBTAIN DEGREE DISTRIBUTIONS OF $Z^A$ AND Z — S2

DETERMINE POSITIONS OF "1"s IN COLUMN THAT IS CLASSIFIED AS LARGE-COLUMN-DEGREE COLUMN IN MASK MATRIX $Z_A$ SO AS TO SATISFY CONDITION FOR PRIORITY LEVEL #1 — S3

DETERMINE POSITIONS OF "1"s IN COLUMN THAT IS CLASSIFIED AS SMALL-COLUMN-DEGREE COLUMN IN MASK MATRIX $Z_A$ SO AS TO SATISFY CONDITIONS FOR PRIORITY LEVEL #1 AND PRIORITY LEVEL #2 — S4

DETERMINE POSITIONS OF "1"s IN COLUMN THAT IS CLASSIFIED AS LARGE-COLUMN-DEGREE COLUMN IN MASK MATRIX Z SO AS TO SATISFY CONDITION FOR PRIORITY LEVEL #1 — S5

DETERMINE POSITIONS OF "1"s IN COLUMN THAT IS CLASSIFIED AS SMALL-COLUMN-DEGREE COLUMN IN MASK MATRIX Z SO AS TO SATISFY CONDITIONS FOR PRIORITY LEVEL #1 AND PRIORITY LEVEL #2 — S6

END

EP 2 053 751 A1

**Description**

TECHNICAL FIELD

The present invention relates to an encoding technology in digital communications, and more particularly, to a check-matrix generating method of generating a parity check matrix for LDPC (low-density parity check) code, an encoding method of encoding predetermined data bits using the parity check matrix, and a decoding method.

BACKGROUND ART

Hereinafter, a conventional communication system that employs an LDPC code as an encoding system will be explained. Here, a case in which quasi-cyclic (QC) codes (see Nonpatent Document 1) are employed as an example of the LDPC codes will be explained.
First, the procedure of encoding/decoding processing in the conventional communication system that employs the LDPC codes as the encoding system will be explained briefly.
An LDPC encoder in a communication apparatus on a transmission-side (it is called a transmission apparatus) generates a parity check matrix H by a conventional method that will be explained below. Further, the LDPC encoder generates, for example, a generator matrix G with K-rows $\times$ N-columns (K: data length, N: code length). Note that when the parity check matrix for LDPC is defined as H (M-rows $\times$ N-columns), the generator matrix G will be a matrix that satisfies $GH^T=0$ (T is a transposed matrix).
Thereafter, the LDPC encoder receives a message $(m_1, m_2, \cdots, m_K)$ with the data length K to generate a code C as represented by following Equation (1) using these messages and the generator matrix G, where $H(c_1, c_2, \cdots, C_N)^T=0$.

$$C=(m_1, \ m_2, \ \cdots, \ m_K) \, G$$

$$=(c_1, \ c_2, \ \cdots, \ c_N) \qquad \cdots (1)$$

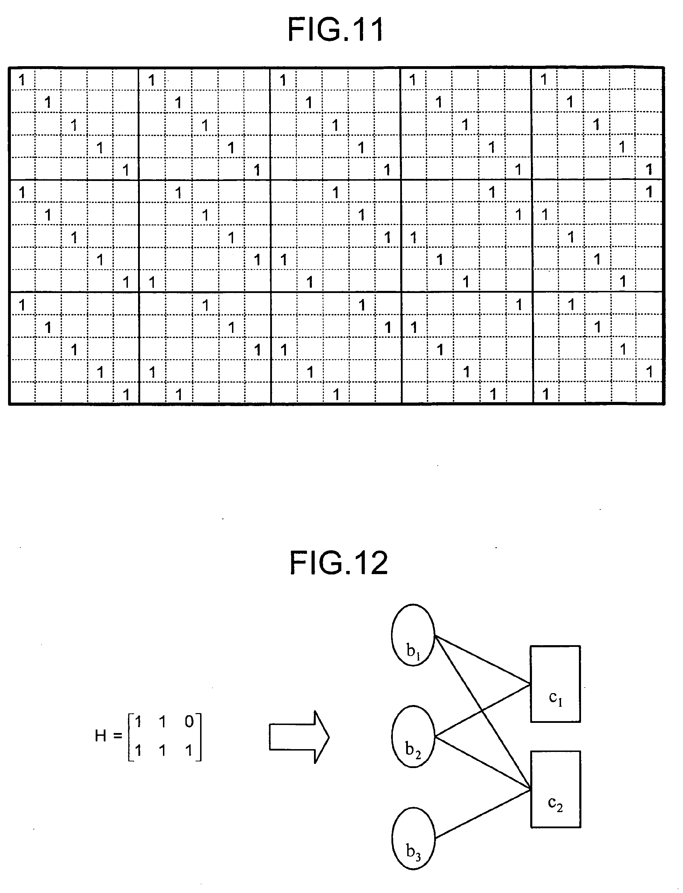

A modulator in the transmission apparatus then performs digital modulation to the code C generated by the LDPC encoder according to a predetermined modulation system, such as BPSK (binary phase shift keying), QPSK (quadrature phase shift keying), m-ary QAM (quadrature amplitude modulation), and transmits a modulated signal $x=(x_1, x_2, \cdots, x_N)$ to a reception apparatus.
Meanwhile, in a communication apparatus on a reception-side (which is called a reception apparatus), a demodulator performs digital demodulation to a received modulated signal $y=(y_1, y_2, \cdots, y_N)$ according to the modulation system such as BPSK, QPSK, m-ary QAM, or the like, and an LDPC decoder in the reception apparatus further performs repetition decoding to demodulated results based on a "sum-product algorithm" to thereby output the decoded results (corresponding to the original messages $m_1, m_2, \cdots, m_K$).
The conventional parity check-matrix generating method for the LDPC codes will now be explained concretely. As the parity check matrix for the LDPC codes, a following parity check matrix of QC codes is proposed, for example, in following Nonpatent Document 1 (see Fig. 11). The parity check matrix of the QC codes shown in Fig. 11 is a matrix in which cyclic permutation matrices (P=5) with 5-rows x 5-columns are arranged in a vertical direction (J=3) and in a horizontal direction (L=5).
Generally, a parity check matrix $H_{QC}$ of the (J, L) QC codes with M (=pJ) rows $\times$ N (=pL) columns can be defined as following Equation (2). Incidentally, p is an odd prime number (other than 2), L is the number of cyclic permutation matrices in the parity check matrix $H_{QC}$ in a transverse direction (column direction), and J is the number of cyclic permutation matrices in the parity check matrix $H_{QC}$ in a longitudinal direction (row direction).
[Numerical Expression 1]

$$H_{QC} = \begin{bmatrix} I(p_{0,0}) & I(p_{0,1}) & \vdots & I(p_{0,L-1}) \\ I(p_{1,0}) & I(p_{1,1}) & \vdots & I(p_{1,L-1}) \\ \vdots & \vdots & \ddots & \vdots \\ I(p_{J-1,0}) & I(p_{J-1,1}) & \vdots & I(p_{J-1,L-1}) \end{bmatrix}$$

$$\text{Example:} \quad p = 5, I(0) = \begin{bmatrix} 1 & 0 & 0 & 0 & 0 \\ 0 & 1 & 0 & 0 & 0 \\ 0 & 0 & 1 & 0 & 0 \\ 0 & 0 & 0 & 1 & 0 \\ 0 & 0 & 0 & 0 & 1 \end{bmatrix} \quad \cdots (2)$$

Where, in $0 \le j \le J-1$ and $0 \le l \le L-1$, $I(p_{j,l})$ are cyclic permutation matrices in which positions of a row index: r ($0 \le r \le P-1$), and a column index: "$(r+p_{j,l})$mod p" are "1s", and other positions are "0s".

In addition, when the LDPC codes are designed, performance degradation generally occurs when there are many loops with a short length, and thus it is necessary to increase a girth and to reduce the number of loops with the short length (loop 4, loop 6, or the like).

Incidentally, Fig. 12 is a schematic diagram illustrating an example of the check matrix represented by a Tanner graph, wherein in the binary parity check matrix H of {0,1} with M-rows × N-columns, nodes corresponding to each column are called bit nodes $b_n$ ($1 \le n \le N$) (corresponding to circles in the figure), and nodes corresponding to each row are called check nodes $c_m$ ($1 \le m \le M$) (corresponding to rectangles in the figure), and further, when there is "1" at an intersection of the row and the column of the check matrix, a bipartite graph in which the bit nodes and the check nodes are connected with edges is called the Tanner graph. In addition, the loop represents a closed loop that starts from a specific node (corresponding to circles and rectangles in the figure) and ends at that node as shown in Fig. 12, and the girth means the minimum loop thereof. Moreover, a loop length is represented by the number of edges constituting the closed loop, and is simply represented as loop 4, loop 6, loop 8, ··· according to the length.

Meanwhile, in following Nonpatent Document 1, a range of an girth g in the parity check matrix $H_{QC}$ of (J,L) QC-LDPC codes is given by "$4 \le g \le 12$ (where g is an even number)". However, it is easy to avoid g=4 and, it results in $g \ge 6$ in many cases.

Nonpatent Document 1: M. Fossorier, "Quasi-Cyclic Low Density Parity Check Code", ISIT2003, pp150, Japan, June 29-July 4, 2003.

DISCLOSURE OF INVENTION

PROBLEM TO BE SOLVED BY THE INVENTION

According to the conventional technology, however, a plurality of totally different check matrices is required to change encoding rates, so that there are problems that a memory amount is increased and a circuit becomes complicated.

The present invention has been made to solve the above-mentioned problems, and it is an object of the present invention to obtain a check-matrix generating method capable of generating an irregular (weights of a row and a column are nonuniform) parity check matrix for LDPC codes that can deal with a wide range of encoding rates, and also capable of reducing the circuit scale as compared with the conventional technology.

MEANS FOR SOLVING PROBLEM

To solve the above problems and to achieve the object, a check-matrix generating method according to the present invention is for generating a parity check matrix for an LDPC (Low-Density Parity Check) code. The check-matrix generating method includes a quasi-cyclic matrix generating step of generating a regular (weights of a row and a column are uniform) quasi-cyclic matrix in which cyclic permutation matrices are arranged in a row direction and a column direction and specific regularity is given to the cyclic permutation matrices; a mask-matrix generating step of generating a mask matrix capable of supporting a plurality of encoding rates, for making the regular quasi-cyclic matrix into irregular (weights of a row and a column are nonuniform); a masking step of converting a specific cyclic permutation matrix in the regular quasi-cyclic matrix into a zero-matrix using a mask matrix corresponding to a specific encoding rate to generate an irregular masking quasi-cyclic matrix; and a check-matrix generating step of generating an irregular parity check matrix with an LDGM (low-density generation matrix) structure in which the masking quasi-cyclic matrix and a matrix in which the cyclic permutation matrices are arranged in a staircase manner are arranged in a predetermined location. The mask-matrix generating step includes a degree distribution calculating step of sequentially calculating a column degree distribution of a first mask matrix corresponding to an encoding rate (first encoding rate) equal to or lower than 1/2 serving as a reference, a column degree distribution of a second mask corresponding to a second encoding rate that is an encoding rate next lower than the first encoding rate by using the column degree distribution of the first mask matrix as a restriction condition, and, as required, a column degree distribution of a third mask matrix, a column degree distribution of a fourth mask matrix, ···, each by using a column degree distribution of an immediately preceding mask matrix as a restriction condition, and a weight-position determining step of determining weight positions in columns of each of the mask matrices in order from the first mask matrix having a highest encoding rate based on the column degree distribution of the mask matrix. The check-matrix generating step includes generating a check matrix corresponding to the encoding rate equal to or lower than 1/2 first.

EFFECT OF THE INVENTION

According to the present invention, there is an effect that it is possible to generate an irregular parity check matrix for the LDPC codes capable of dealing with a wide range of encoding rates.

BRIEF DESCRIPTION OF DRAWINGS

[Fig. 1] Fig. 1 is a schematic diagram illustrating a configuration example of a communication system including an LDPC encoder and an LDPC decoder.
[Fig. 2-1] Fig. 2-1 is a flowchart for explaining a masking rule for generating a mask matrix Z for codes corresponding to encoding rate 1/3.
[Fig. 2-2] Fig. 2-2 is a table for explaining the masking rule for generating the mask matrix Z for codes corresponding to encoding rate 1/3.

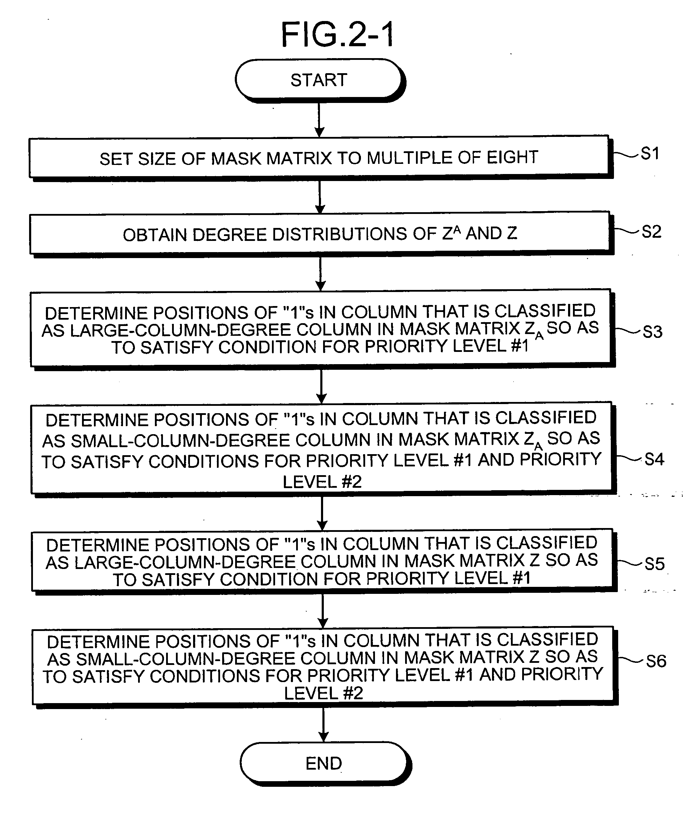

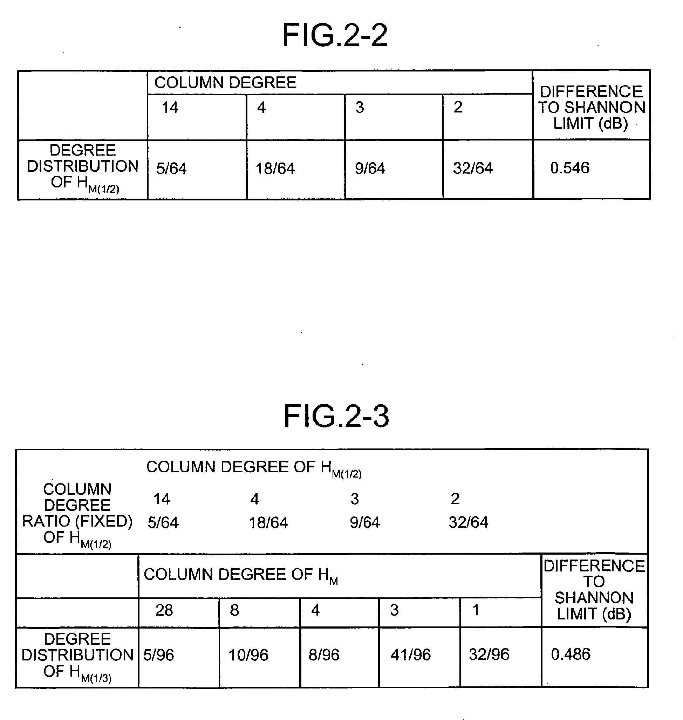

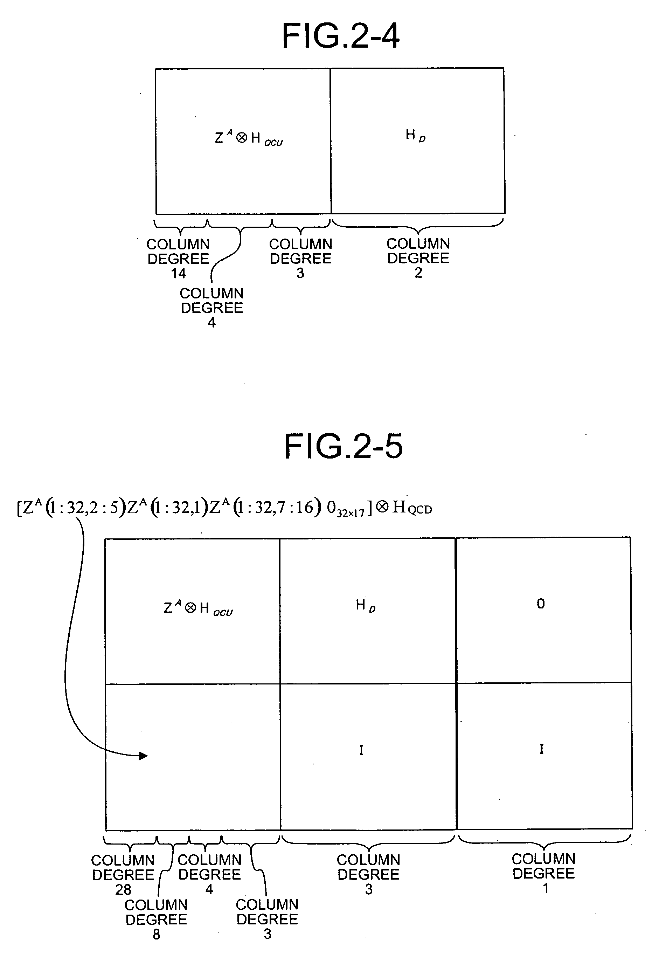

[Fig. 2-3] Fig. 2-3 is a table for explaining the masking rule for generating the mask matrix Z for codes corresponding to encoding rate 1/3.
[Fig. 2-4] Fig. 2-4 is a schematic diagram for explaining the masking rule for generating the mask matrix Z for codes corresponding to encoding rate 1/3.
[Fig. 2-5] Fig. 2-5 is a schematic diagram for explaining the masking rule for generating the mask matrix Z for codes corresponding to encoding rate 1/3.

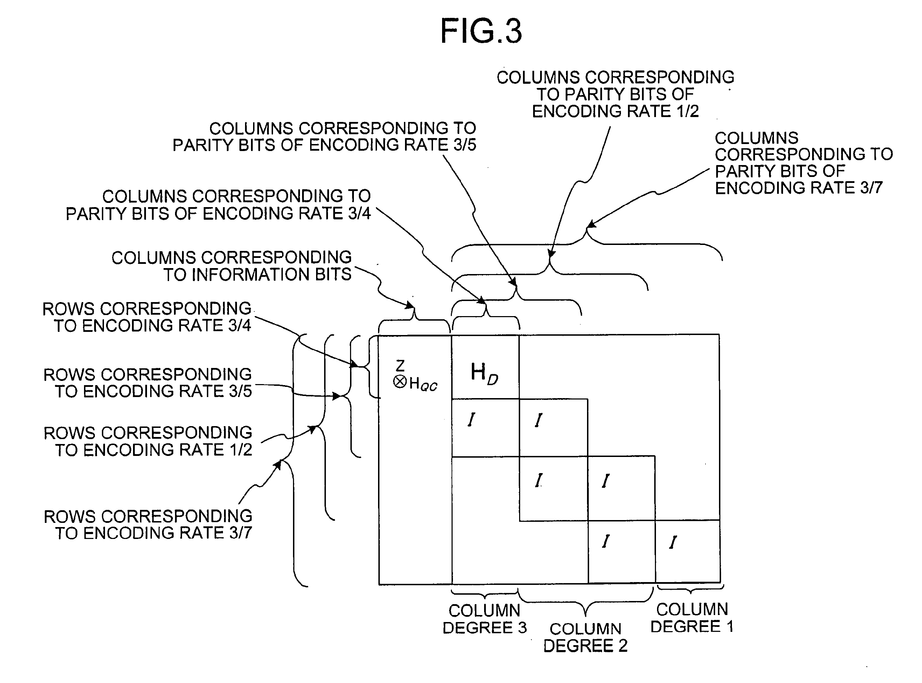

[Fig. 3] Fig. 3 is a schematic diagram illustrating a configuration example of an irregular parity check matrix $H_M$ after being masked by a mask matrix Z.

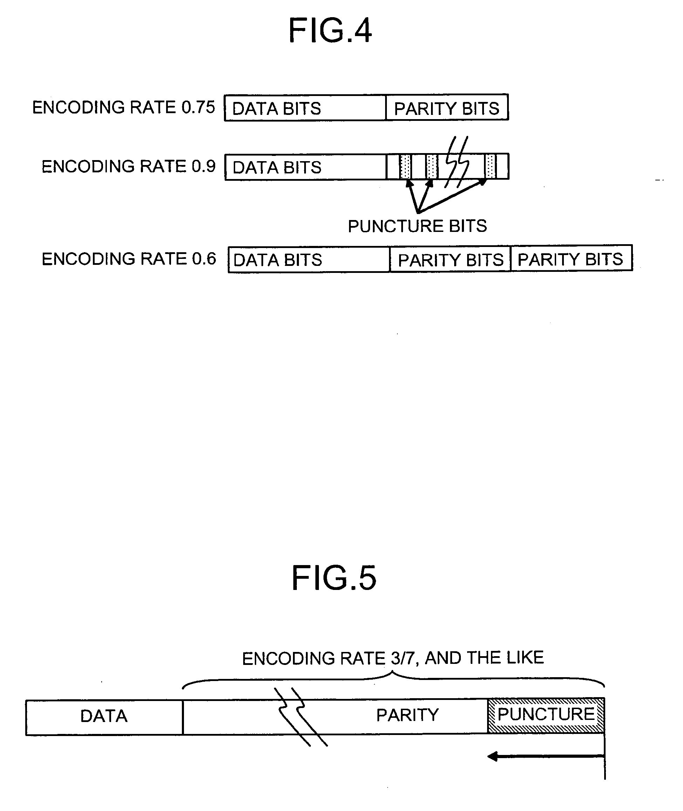

[Fig. 4] Fig. 4 is a schematic diagram illustrating an example of a code configuration method.
[Fig. 5] Fig. 5 is a schematic diagram illustrating a code when the lowest encoding rate prepared by a system is $R_0=3/7$.

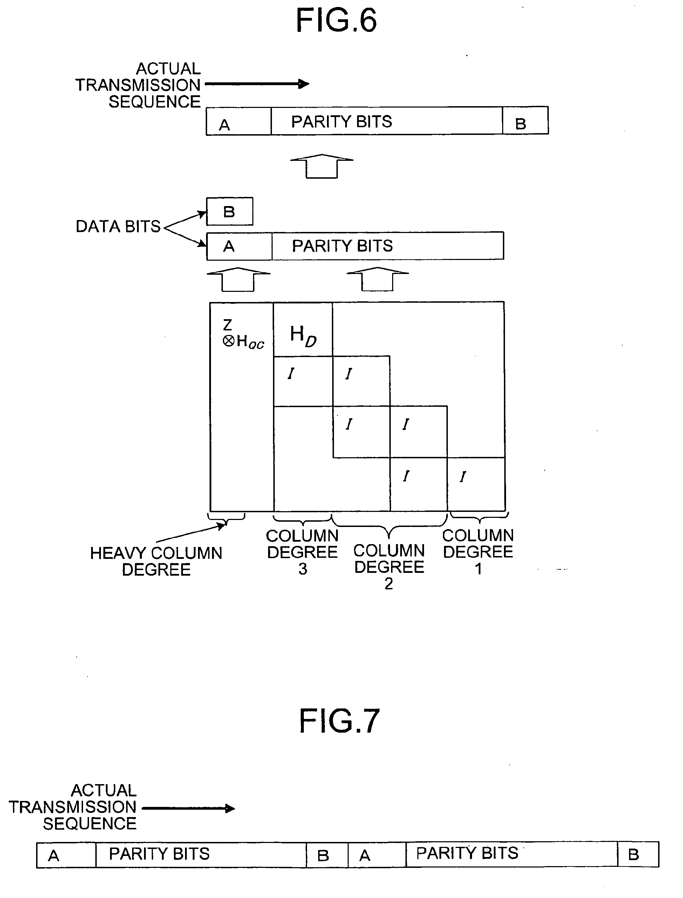

[Fig. 6] Fig. 6 is a schematic diagram illustrating an example of processing for generating a code.
[Fig. 7] Fig. 7 is a schematic diagram illustrating an example of processing for generating a code.

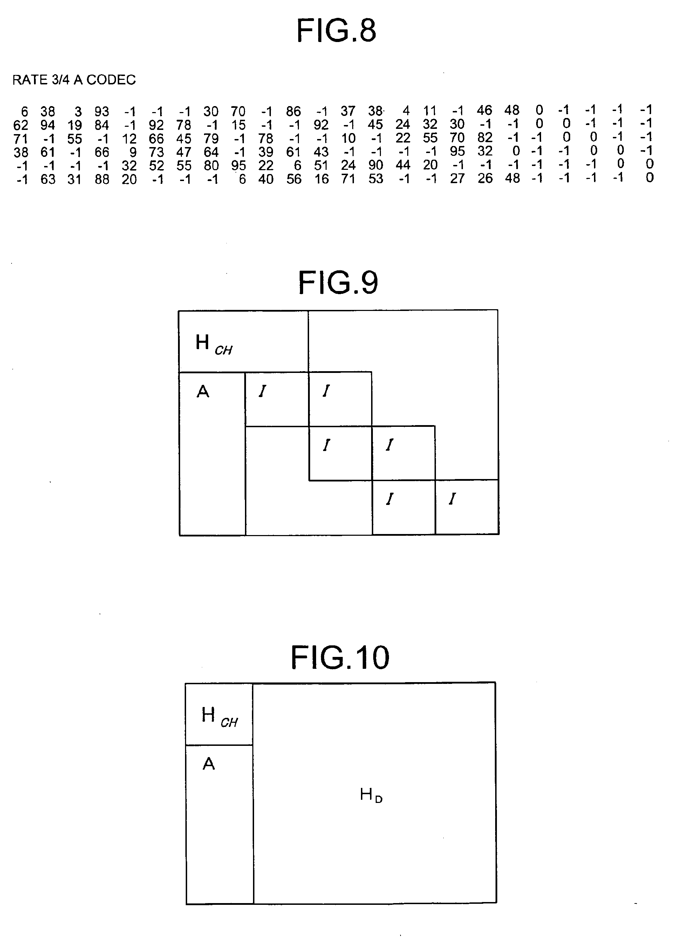

[Fig. 8] Fig. 8 is a schematic diagram illustrating an example of a generally-available matrix for encoding rate 3/4.
[Fig. 9] Fig. 9 is a schematic diagram illustrating an example of a 4Mx(7/3)N matrix $H_{CH}$' derived from an M×N matrix $H_{CH}$ for encoding rate 3/4 formed of the matrix shown in Fig. 8.
[Fig. 10] Fig. 10 is a schematic diagram illustrating an example of a 4Mx(7/3)N matrix $H_{CH}$' derived from an Mx(N-M) matrix $H_{CH}$ configured based on an arbitrary combination of cyclic permutation matrices.
[Fig. 11] Fig. 11 is a schematic diagram illustrating an example of a parity check matrix of QC codes.
[Fig. 12] Fig. 12 is a schematic diagram illustrating a case in which an example of the check matrix is represented by a Tanner graph.

EXPLANATIONS OF LETTERS OR NUMERALS

1   LDPC encoder
2   Modulator

3   Communication channel
4   Demodulator
5   LDPC decoder

BEST MODE(S) FOR CARRYING OUT THE INVENTION

Hereinafter, embodiments of a check-matrix generating method according to the present invention will be explained in detail based on the drawings. Incidentally, the present invention is not limited by these embodiments.

First Embodiment

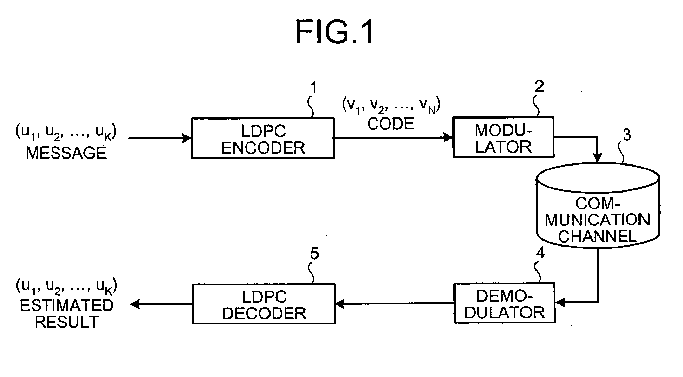

Fig. 1 is a schematic diagram illustrating a configuration example of a communication system including an LDPC encoder and an LDPC decoder according to the present embodiment. In Fig. 1, a communication apparatus (which is called a transmission apparatus) on a transmission-side has a configuration including an LDPC encoder 1 and a modulator 2, and a communication apparatus (which is called a reception apparatus) on a reception-side has a configuration including a demodulator 4 and an LDPC decoder 5.

Here, the procedure of encoding processing and decoding processing in the communication system that employs LDPC codes will be explained briefly.

The LDPC encoder 1 in the transmission apparatus generates a parity check matrix generated by a check-matrix generating method according to the present embodiment, namely, a parity check matrix $H_M$ with M-rows $\times$ N-columns to which masking processing is performed based on a predetermined masking rule described below.

Thereafter, the LDPC encoder 1 receives a message $(u_1, u_2, \cdots, u_K)$ with data length K to generate a code v with a length N using this message and the parity check matrix $H_M$ as represented by following Equation (3). It should be noted that in the present embodiment, the encoding processing of data bits is performed without using the generator matrix G (K: data length, N: code length) calculated in the conventional technology.

$$v=\{(v_1, v_2, \ldots, v_N) \in GF(2)| (v_1, v_2, \ldots, v_N) H_M^T=0\} \quad \cdots (3)$$

The modulator 2 in the transmission apparatus then digital-modulates the code v generated by the LDPC encoder 1 according to a predetermined modulation system, such as BPSK, QPSK, and m-ary QAM, and transmits the modulated signal $x=(x_1, x_2, \cdots, x_N)$ to the reception apparatus via a communication channel 3.

Meanwhile, in the reception apparatus, the demodulator 4 digital-demodulates a modulated signal $y=(y_1, y_2, \cdots, y_N)$ received via the communication channel 3 according to a modulation system, such as the BPSK, QPSK, and m-ary QAM, and the LDPC decoder 5 in the reception apparatus further performs repetition decoding with a well-known decoding algorithm to thereby output the decoded result (corresponding to the original message $u_1, u_2, \cdots, U_K$).

Subsequently, the check-matrix generating method according to the present embodiment will be explained in detail. Incidentally, in the present embodiment, it is supposed that an irregular (weight distribution is nonuniform) parity check matrix is generated, and it is premised that an LDGM (low-density generation matrix) structure is employed as the structure. Moreover, check matrix generation processing of each embodiment explained hereinafter may be performed by the LDPC encoder 1 in the communication apparatus, or may be performed in advance outside the communication apparatus. When it is performed outside the communication apparatus, the generated check matrix is stored in an internal memory.

First, a parity check matrix $H_{QCL}$ of QC-LDPC codes with the LDGM structure, which is a premise for the irregular parity check matrix $H_M$ after the masking processing and is generated by the check matrix generation processing of the present embodiment, will be defined.

For example, the parity check matrix $H_{QCL}$ $(=[h_{m,n}])$ of the QC-LDPC codes with the LDGM structure of M $(=pJ)$ rows $\times$ N $(=pL+pJ)$ columns can be defined as following Equation (4-1).

[Numerical Expression 2-1]

$$H_{QCL} = \begin{bmatrix} I(p_{0,0}) & I(p_{0,1}) & \cdots & I(p_{0,L-1}) & I(0) & 0 & \cdots & \cdots & \cdots & \cdots & \cdots & \cdots & \cdots & \cdots & \cdots & 0 \\ I(p_{1,0}) & I(p_{1,1}) & \cdots & I(p_{1,L-1}) & I(0) & I(0) & 0 & \ddots & \ddots & \ddots & \ddots & \ddots & \ddots & \ddots & \ddots & \vdots \\ \vdots & \vdots & \vdots & \vdots & 0 & \ddots & \ddots & \ddots & \ddots & \ddots & \ddots & \ddots & \ddots & \ddots & \ddots & \vdots \\ I(p_{J/4-1,0}) & I(p_{J/4-1,1}) & \cdots & I(p_{J/4-1,L-1}) & \vdots & \ddots & I(0) & I(0) & 0 & \ddots & \ddots & \ddots & \ddots & \ddots & \ddots & \vdots \\ \vdots & \vdots & \vdots & \vdots & I(0) & 0 & \cdots & 0 & I(0) & 0 & \ddots & \ddots & \ddots & \ddots & \ddots & \vdots \\ \vdots & \vdots & \vdots & \vdots & 0 & I(0) & 0 & \cdots & 0 & I(0) & 0 & \ddots & \ddots & \ddots & \ddots & \vdots \\ \vdots & \vdots & \vdots & \vdots & \vdots & \ddots & \ddots & \ddots & \ddots & \ddots & \ddots & \ddots & \ddots & \ddots & \ddots & \vdots \\ \vdots & \vdots & \vdots & \vdots & 0 & \cdots & 0 & I(0) & 0 & \cdots & 0 & I(0) & 0 & \ddots & \ddots & \vdots \\ \vdots & \vdots & \vdots & \vdots & 0 & \cdots & \cdots & 0 & I(0) & 0 & \cdots & 0 & I(0) & 0 & \ddots & \vdots \\ \vdots & \vdots & \vdots & \vdots & \vdots & \ddots & \ddots & \ddots & 0 & I(0) & 0 & \cdots & 0 & I(0) & \ddots & \vdots \\ \vdots & \vdots & \vdots & \vdots & \vdots & \ddots & \ddots & \ddots & \ddots & \ddots & \ddots & \ddots & \ddots & \ddots & \ddots & 0 \\ I(p_{J-1,0}) & I(p_{J-1,1}) & \cdots & I(p_{J-1,L-1}) & 0 & \cdots & \cdots & \cdots & \cdots & \cdots & 0 & I(0) & 0 & \cdots & 0 & I(0) \end{bmatrix}$$

$$\cdots (4-1)$$

Here, $h_{m,n}$ represents an element at a row index m and a column index n in the parity check matrix $H_{QCL}$. Additionally, in $0 \leq j \leq J-1$ and $0 \leq l \leq L-1$, $I(p_{j,l})$ are cyclic permutation matrices in which positions of a row index: r $(0 \leq r \leq p-1)$, and a column index: "$(r+p_{j,l})$mod p" are "1s", and other positions are "0s". For example, I(1) can be represented as following Equation (4-2).

[Numerical Expression 2-2]

$$I(1) = \begin{bmatrix} 0 & 1 & 0 & \cdots & 0 \\ 0 & 0 & 1 & \cdots & 0 \\ \cdots & \cdots & \cdots & \cdots & \cdots \\ 0 & 0 & 0 & \cdots & 1 \\ 1 & 0 & 0 & \cdots & 0 \end{bmatrix} \qquad \cdots (4-2)$$

In the parity check matrix $H_{QCL}$, a left-hand side matrix (a portion corresponding to data bits) is a quasi-cyclic matrix $H_{QC}$ that is the same as the parity check matrix of QC codes shown by Equation (2), and a right-hand side matrix (a portion corresponding to parity bits) is a matrix $H_T$ or $H_D$ in which I(0) are arranged in a staircase manner as shown in following Equation (5-1) or Equation (5-2). Meanwhile, I represents a unit matrix and 0 represents a zero matrix in Equation (5-1) and Equation (5-2).

[Numerical Expression 3-1]

$$H_T := \begin{bmatrix} H_D & 0 & 0 & 0 \\ I & I & 0 & 0 \\ 0 & I & I & 0 \\ 0 & 0 & I & I \end{bmatrix} \qquad \cdots (5-1)$$

[Numerical Expression 3-2]

$$H_D := \begin{bmatrix} I(0) & 0 & \cdots & \cdots & 0 \\ I(0) & I(0) & 0 & \ddots & \vdots \\ 0 & \ddots & \ddots & \ddots & \vdots \\ \vdots & \ddots & I(0) & I(0) & 0 \\ 0 & \cdots & 0 & I(0) & I(0) \end{bmatrix} \cdots (5\text{-}2)$$

However, the cyclic permutation matrices used in the staircase structure are not necessarily limited to I(0), but may be a combination of arbitrary I(s|s∈[0, p-1]).

Note that, the LDGM structure means a structure in which a part of the parity check matrix is formed into a lower triangular matrix as the matrix shown in Equation (4-1). Encoding can be achieved easily by using this structure without using the generator matrix G. For example, when the systematic code v is represented as following Equation (6), and the information message $u=(u_1, u_2, \cdots, u_K)$ is given, parity elements $p_m=(p_1, p_2, \cdots, p_M)$ are generated so that "$H_{QCL} \cdot v^T=0$" may be satisfied, namely as following Equation (7).

$$v = (v_1, v_2, \dots v_K, v_{K+1}, v_{K+2}, \dots, v_N)$$

$$= (u_1, u_2, \dots u_K, p_1, p_2, \dots, p_M) \quad \cdots (6)$$

where N=K+M.

[Numerical Expression 4]

$$p_m = \sum_{n=1}^{K+m-1} v_n h_{m,n}$$

$$1 \leq m \leq M \qquad \cdots (7)$$

$$1 \leq n \leq N$$

Further, in the present embodiment, a specific regularity is provided in the parity check matrix $H_{QCL}$ of the QC-LDPC codes with the LDGM structure defined as Equation (4-1). Specifically, in the quasi-cyclic matrix $H_{QC}$ portion on the left-hand side of the parity check matrix $H_{QCL}$, if $p_{0,l}$ is set to an arbitrary integer, a specific regularity is provided to $p_{j,l}$ of the cyclic permutation matrices $I(p_{j,l})$ with p-row × p-column arranged at a row index j (=0, 1, 2, ··· J-1) and a column index 1 (=0, 1, 2, ··· L-1) so as to satisfy Equation (8-1), Equation (8-2), Equation (8-3), or Equation (8-4) below.

$$p_{j,l} = p_{0,l}(j+1) \bmod p \qquad \cdots (8\text{-}1)$$

$$p_{j,l} = ((p - p_{0,l})(j+1)) \bmod p \quad \cdots (8\text{-}2)$$

$$p_{j,1} = (((p_A - p_{0,1})(j+1)) \bmod p_A) \bmod p$$

$$p_A = 157$$

$$0 \leq j \leq J-1$$

$$p: \text{prime number} \qquad \cdots (8-3)$$

$$p_{j,1} = ((p_{0,1}(j+1)) \bmod p_A) \bmod p$$

$$p_A = 157$$

$$0 \leq j \leq J-1$$

$$p: \text{prime number} \qquad \cdots (8-4)$$

The value of $p_A$ is desirably determined such that the most satisfactory performance is achieved for data having the maximum length of system requirement. The above "$p_A=157$" is a value obtained on an assumption that the data length pxL(=36) is in the neighborhood of 5000 to 6000.

For example, by using Equation (8-4) with L=36, an example as represented by Equation (9) below is obtained.

$$\{p_{0,1}, \ p_{0,2}, \ p_{0,3}, \ p_{0,4}, \ p_{0,5}, \ p_{0,6}, \ p_{0,7}, \ p_{0,8}, \ p_{0,9}, \ p_{0,10},$$
$$p_{0,11}, \ p_{0,12}, \ p_{0,13}, \ p_{0,14}, \ p_{0,15}, \ p_{0,16}, \ p_{0,17}, \ p_{0,18}, \ p_{0,19}, \ p_{0,20},$$
$$p_{0,21}, \ p_{0,22}, \ p_{0,23}, \ p_{0,24}, \ p_{0,25}, \ p_{0,26}, \ p_{0,27}, \ p_{0,28}, \ p_{0,29}, \ p_{0,30},$$
$$p_{0,31}, \ p_{0,32}, \ p_{0,33}, \ p_{0,34}, \ p_{0,35}, \ p_{0,36}\}$$
$$= \{7, \ 87, \ 36, \ 15, \ 53, \ 11, \ 16, \ 136, \ 59, \ 45, \ 137, \ 31, \ 56,$$
$$66, \ 31, \ 37, \ 2, \ 22, \ 131, \ 21, \ 6, \ 92, \ 56, \ 72, \ 53, \ 23, \ 21, \ 36,$$
$$73, \ 127, \ 25, \ 15, \ 10, \ 1, \ 107, \ 18\} \qquad \cdots (9)$$

Next, the mask processing for the parity check matrix $H_{QCL}$ which is specific processing in the check-matrix generating method according to the present embodiment will be explained.

For example, when the left-hand side matrix shown in Equation (4-1) is represented by the quasi-cyclic matrix $H_{QC}$ of J × L as shown in following Equation (10-1), and a mask matrix Z ($=[z_{j,l}]$) is defined as a matrix with J-rows × L-columns on GF(2), the matrix $H_{MQC}$ after the mask processing can be represented as following Equation (10-2) if a predetermined rule described below is applied.

[Numerical Expression 5-1]

$$H_{QC} := \begin{bmatrix} I(p_{0,0}) & I(p_{0,1}) & \cdots & I(p_{0,L-1}) \\ I(p_{1,0}) & I(p_{1,1}) & \cdots & I(p_{1,L-1}) \\ \vdots & \vdots & \ddots & \vdots \\ I(p_{J-1,0}) & I(p_{J-1,1}) & \cdots & I(p_{J-1,L-1}) \end{bmatrix} \qquad \cdots (10-1)$$

[Numerical Expression 5-2]

$$H_{MQC} = Z \otimes H_{QC} = \begin{bmatrix} z_{0,0}I(p_{0,0}) & z_{0,1}I(p_{0,1}) & \cdots & z_{0,L-1}I(p_{0,L-1}) \\ z_{1,0}I(p_{1,0}) & z_{1,1}I(p_{1,1}) & \cdots & z_{1,L-1}I(p_{1,L-1}) \\ \vdots & \vdots & \ddots & \vdots \\ z_{J-1,0}I(p_{J-1,0}) & z_{J-1,1}I(p_{J-1,1}) & \cdots & z_{J-1,L-1}I(p_{J-1,L-1}) \end{bmatrix}$$

$$\cdots (10-2)$$

Here, $z_{j,l}I(p_{j,l})$ in Equation (10-2) is defined as following Equation (11).

[Numerical Expression 6]

$$z_{j,l}I(p_{j,l}) = \begin{cases} I(p_{j,l}) & \text{for } z_{j,l} = 1 \\ 0 & \text{for } z_{j,l} = 0 \end{cases} \quad \cdots (11)$$

The zero-matrix is a zero-matrix with p-rows $\times$ p-columns. Additionally, the matrix $H_{MQC}$ is a matrix in which the quasi-cyclic matrix $H_{QC}$ is masked with 0-elements of the mask matrix Z, and the weight distribution is nonuniform (irregular), while a distribution of the cyclic permutation matrices of the matrix $H_{MQC}$ is the same as a degree distribution of the mask matrix Z.

Note that a weight distribution of the mask matrix Z when the weight distribution is nonuniform shall be determined by a predetermined density evolution method as described later. For example, the mask matrix with 48-rows $\times$ 36-columns can be represented as following Equations (12-1) to (12-5) based on a column degree distribution by the density evolution method.

[Numerical Expression 7-1]

$$Z = \begin{bmatrix} Z^A \\ Z^B \\ Z^C \\ Z^D \end{bmatrix} \quad \cdots (12-1)$$

[Numerical Expression 7-2]

$$Z^A = \begin{bmatrix} 0 & 1 & 1 & 1 & 0 & 0 & 0 & 1 & 0 & 1 & 0 & 1 & 0 & 0 & 0 & 1 & 0 & 0 & 0 & 1 & 0 & 0 & 0 & 1 & 0 & 0 & 0 & 1 & 0 & 0 & 0 & 0 & 0 & 0 & 1 \\ 1 & 0 & 0 & 0 & 1 & 1 & 0 & 0 & 1 & 0 & 0 & 0 & 0 & 1 & 0 & 1 & 0 & 1 & 0 & 0 & 1 & 0 & 0 & 0 & 1 & 0 & 0 & 1 & 0 & 0 & 0 & 1 & 0 & 0 & 0 \\ 0 & 1 & 0 & 1 & 0 & 0 & 1 & 0 & 0 & 1 & 1 & 0 & 0 & 1 & 0 & 1 & 0 & 0 & 0 & 0 & 0 & 1 & 0 & 1 & 0 & 1 & 0 & 0 & 1 & 0 & 0 & 0 & 0 & 0 & 0 \\ 1 & 0 & 0 & 0 & 1 & 0 & 0 & 1 & 0 & 0 & 0 & 1 & 1 & 0 & 0 & 0 & 1 & 1 & 0 & 0 & 0 & 0 & 0 & 0 & 1 & 0 & 0 & 0 & 1 & 0 & 0 & 0 & 1 & 0 & 0 \\ 0 & 0 & 1 & 1 & 0 & 0 & 1 & 0 & 1 & 1 & 0 & 0 & 0 & 0 & 1 & 0 & 0 & 0 & 1 & 1 & 1 & 0 & 0 & 1 & 0 & 0 & 0 & 0 & 0 & 0 & 1 & 0 & 0 & 0 & 1 & 0 \\ 1 & 1 & 0 & 0 & 1 & 1 & 0 & 0 & 0 & 0 & 1 & 0 & 1 & 0 & 0 & 0 & 0 & 0 & 1 & 0 & 0 & 0 & 1 & 0 & 0 & 0 & 1 & 0 & 0 & 0 & 0 \\ 0 & 0 & 1 & 1 & 0 & 0 & 1 & 0 & 1 & 0 & 0 & 0 & 0 & 1 & 0 & 1 & 1 & 0 & 1 & 0 & 1 & 0 & 0 & 0 & 0 & 0 & 0 & 0 & 0 & 0 & 1 & 0 & 0 & 0 & 1 & 0 \\ 1 & 0 & 0 & 0 & 1 & 0 & 0 & 1 & 0 & 0 & 1 & 1 & 0 & 0 & 0 & 0 & 0 & 1 & 0 & 1 & 0 & 0 & 1 & 0 & 0 & 0 & 0 & 1 & 0 & 0 & 0 & 1 & 0 & 0 & 0 \\ 0 & 1 & 1 & 0 & 0 & 1 & 0 & 0 & 0 & 1 & 0 & 0 & 1 & 0 & 1 & 0 & 0 & 0 & 1 & 0 & 1 & 0 & 0 & 0 & 1 & 0 & 0 & 0 & 0 & 0 & 1 & 0 & 0 & 0 & 0 & 1 \\ 1 & 0 & 0 & 1 & 1 & 0 & 0 & 0 & 1 & 0 & 0 & 1 & 0 & 1 & 0 & 1 & 0 & 1 & 0 & 0 & 0 & 1 & 0 & 0 & 0 & 0 & 1 & 0 & 0 & 1 & 0 & 0 & 0 & 1 & 0 & 0 \\ 0 & 0 & 1 & 0 & 0 & 0 & 1 & 1 & 0 & 0 & 1 & 0 & 1 & 0 & 1 & 0 & 1 & 0 & 0 & 0 & 0 & 0 & 1 & 0 & 0 & 1 & 0 & 0 & 1 & 0 & 0 & 0 & 0 & 0 & 1 & 0 \\ 0 & 1 & 0 & 0 & 0 & 1 & 0 & 0 & 0 & 1 & 0 & 0 & 0 & 1 & 0 & 0 & 0 & 0 & 1 & 1 & 0 & 0 & 0 & 1 & 0 & 0 & 0 & 1 & 0 & 0 & 0 & 1 & 0 & 0 & 0 & 0 \end{bmatrix}$$

$\cdots (12-2)$

[Numerical Expression 7-3]

$$Z^B = \begin{bmatrix} 1 & 0 & 1 & 0 & 0 & 0 & 1 & 0 & 1 & 0 & 1 & 0 & 0 & 0 & 1 & 0 & 0 & 0 & 0 & 0 & 0 & 0 & 0 & 0 & 0 & 0 & 0 & 0 & 0 & 0 & 1 & 0 & 0 & 0 & 0 \\ 0 & 1 & 0 & 1 & 1 & 0 & 0 & 1 & 0 & 0 & 0 & 0 & 1 & 0 & 1 & 0 & 0 & 0 & 0 & 0 & 0 & 0 & 0 & 0 & 0 & 0 & 0 & 0 & 1 & 0 & 0 & 0 & 0 \\ 1 & 0 & 1 & 0 & 0 & 1 & 0 & 0 & 1 & 1 & 0 & 0 & 1 & 0 & 1 & 0 & 0 & 0 & 0 & 0 & 0 & 0 & 0 & 0 & 0 & 0 & 0 & 0 & 0 & 1 & 0 & 0 & 0 & 0 \\ 0 & 0 & 0 & 1 & 0 & 0 & 1 & 0 & 0 & 0 & 1 & 1 & 0 & 0 & 0 & 1 & 0 & 0 & 0 & 0 & 1 & 0 & 0 & 0 & 0 & 0 & 0 & 1 & 0 & 0 & 0 & 0 \\ 0 & 1 & 1 & 0 & 0 & 1 & 0 & 1 & 1 & 0 & 0 & 0 & 1 & 0 & 0 & 0 & 0 & 0 & 0 & 0 & 0 & 1 & 0 & 0 & 0 & 1 & 0 & 0 & 0 & 0 \\ 1 & 0 & 0 & 1 & 1 & 0 & 0 & 0 & 0 & 1 & 0 & 1 & 0 & 0 & 0 & 0 & 0 & 0 & 0 & 0 & 0 & 0 & 0 & 0 & 0 & 1 & 0 & 0 & 0 & 0 \\ 0 & 1 & 0 & 0 & 0 & 1 & 0 & 1 & 0 & 1 & 0 & 0 & 0 & 1 & 0 & 0 & 0 & 0 & 0 & 0 & 0 & 0 & 0 & 0 & 0 & 0 & 0 & 0 & 0 & 0 \\ 1 & 0 & 1 & 1 & 0 & 0 & 1 & 0 & 0 & 0 & 0 & 1 & 0 & 1 & 0 & 0 & 0 & 0 & 0 & 0 & 0 & 0 & 0 & 0 & 0 & 0 & 0 & 0 & 0 & 0 \\ 0 & 1 & 0 & 0 & 1 & 0 & 0 & 1 & 1 & 0 & 0 & 1 & 0 & 1 & 0 & 0 & 0 & 0 & 0 & 0 & 0 & 0 & 0 & 0 & 0 & 0 & 0 & 0 & 0 \\ 0 & 0 & 1 & 0 & 0 & 1 & 0 & 0 & 0 & 1 & 1 & 0 & 0 & 0 & 1 & 1 & 0 & 0 & 0 & 0 & 0 & 0 & 0 & 0 & 0 & 0 & 0 & 1 & 0 & 0 \\ 1 & 1 & 0 & 0 & 1 & 0 & 1 & 1 & 0 & 0 & 0 & 0 & 1 & 0 & 0 & 0 & 0 & 0 & 0 & 0 & 0 & 0 & 0 & 0 & 0 & 0 & 0 & 0 & 0 & 0 \\ 0 & 0 & 1 & 1 & 0 & 0 & 0 & 0 & 1 & 0 & 1 & 0 & 0 & 0 & 0 & 1 & 0 & 0 & 0 & 0 & 0 & 0 & 0 & 0 & 0 & 0 & 0 & 0 & 0 & 0 \end{bmatrix}$$

$\cdots (12-3)$

[Numerical Expression 7-4]

$$Z^C = \begin{bmatrix} 0 & 1 & 0 & 0 & 0 & 1 & 0 & 1 & 0 & 1 & 0 & 0 & 0 & 0 & 0 & 1 & 0 & 0 & 0 & 0 & 0 & 0 & 0 & 0 & 0 & 0 & 0 & 0 & 1 & 0 & 0 & 0 & 0 \\ 1 & 0 & 1 & 1 & 0 & 0 & 1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 \\ 0 & 1 & 0 & 0 & 1 & 0 & 0 & 1 & 1 & 0 & 0 & 1 & 0 & 0 & 0 & 0 & 0 & 0 & 0 & 0 & 0 & 0 & 0 & 0 & 0 & 0 & 0 & 0 & 0 \\ 0 & 0 & 1 & 0 & 0 & 1 & 0 & 0 & 1 & 1 & 0 & 0 & 0 & 0 & 0 & 0 & 0 & 1 & 0 & 0 & 0 & 0 & 0 & 0 & 0 & 1 & 0 & 0 & 0 & 0 \\ 1 & 1 & 0 & 0 & 1 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 \\ 0 & 0 & 1 & 1 & 0 & 0 & 0 & 0 & 1 & 0 & 1 & 1 & 0 & 0 & 0 & 0 & 0 & 0 & 0 & 0 & 0 & 0 & 0 & 0 & 0 & 0 & 0 & 0 & 0 \\ 1 & 0 & 0 & 0 & 1 & 0 & 1 & 0 & 1 & 1 & 0 & 0 & 0 & 0 & 0 & 0 & 0 & 0 & 0 & 0 & 0 & 0 & 0 & 0 & 1 & 0 & 0 & 0 & 0 \\ 0 & 1 & 1 & 0 & 0 & 1 & 0 & 0 & 0 & 0 & 1 & 0 & 0 & 0 & 0 & 0 & 0 & 0 & 0 & 0 & 0 & 0 & 0 & 0 & 0 & 0 & 0 & 0 \\ 1 & 0 & 0 & 1 & 0 & 0 & 1 & 1 & 0 & 0 & 1 & 0 & 0 & 0 & 0 & 0 & 0 & 0 & 0 & 0 & 0 & 0 & 0 & 0 & 0 & 0 & 0 & 0 \\ 0 & 1 & 0 & 0 & 1 & 0 & 0 & 0 & 1 & 1 & 0 & 0 & 0 & 0 & 0 & 0 & 0 & 0 & 0 & 0 & 0 & 0 & 1 & 0 & 0 & 0 & 0 \\ 1 & 0 & 0 & 1 & 0 & 1 & 1 & 0 & 0 & 1 & 1 & 0 & 0 & 0 & 0 & 0 & 0 & 0 & 0 & 0 & 0 & 0 & 0 & 0 & 0 & 0 & 0 \\ 0 & 0 & 1 & 0 & 0 & 0 & 0 & 1 & 0 & 1 & 0 & 0 & 0 & 0 & 0 & 0 & 0 & 0 & 0 & 0 & 0 & 0 & 0 & 1 & 0 & 0 & 0 \end{bmatrix}$$

$\cdots (12-4)$

[Numerical Expression 7-5]

$$Z^D = \begin{bmatrix}
1 & 1 & 1 & 0 & 0 & 0 & 1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 1 & 0 \\
0 & 0 & 0 & 1 & 1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 1 & 0 & 0 & 0 & 0 & 0 & 0 \\
0 & 0 & 0 & 1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 1 \\
0 & 1 & 1 & 0 & 0 & 1 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 1 & 1 & 0 & 0 & 1 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 1 & 0 & 0 & 0 & 0 & 0 \\
0 & 0 & 0 & 1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
1 & 1 & 0 & 0 & 1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
0 & 0 & 1 & 1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 1 & 0 & 0 & 0 & 0 \\
0 & 1 & 0 & 0 & 0 & 1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 \\
1 & 0 & 0 & 0 & 1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 \\
\end{bmatrix}$$

$$\cdots (12\text{-}5)$$

Hence, the irregular parity check matrix $H_M$ to be finally determined in the present embodiment can be represented as following Equation (13) using, for example, the mask matrix Z with 48-rows × 36-columns, the quasi-cyclic matrix $H_{QC}$ with 48 rows (row index j is 0 to 47) × 36 columns (column index 1 is 0 to 31), and $H_T$ of 48 rows (row index j is 0 to 47) × 48 columns (column index l is 0 to 47).

$$H_M = [Z \times H_{QC} | H_T]$$

$$= [H_{MQC} | H_T] \qquad \cdots (13)$$

Namely, the parity check matrix $H_{MQC}$ for generating the LDPC codes C is given by a design of the mask matrix Z and a value of the cyclic permutation matrix at the row index j=0 of the quasi-cyclic matrix $H_{QC}$.

The masking rule according to the present embodiment will be described concretely. In the present embodiment, a code configuration method for encoding rates equal to or higher than 3/7 will be described as an example. In this example, encoding for encoding rate equal to or higher than 3/7 is performed based on a well-known masking rule which will be described later.

Fig. 2-1 is a flowchart for explaining mask-matrix generation processing according to the present embodiment. Prior to the description about the code configuration method for encoding rates equal to or higher than 3/7, a well-known masking rule will be described with reference to Fig. 2-1. A mask matrix Z for codes corresponding to encoding rate 1/3 will be described as an example.

In this example, it is assumed that the mask matrix generation processing is performed in the LDPC encoder 1 in the communication apparatus. An irregular parity check matrix $H_{M(1/2)}$ for codes corresponding to encoding rate 1/2 is assumed as "$H_{M(1/2)}=[Z^A \times H_{QCU} | H_D]$". Note that $H_{QCU}$ represents a quasi-cyclic matrix of 32 (row index j is 0 to 31) × 32 (column index 1 is 0 to 31) of an upper half of the quasi-cyclic matrix $H_{QC}$. $H_D$ is a matrix given by Equation (5-2) above such as a matrix of 32 (row index j is 0 to 31) × 32 (column index 1 is 0 to 31).

First, the LDPC encoder 1 in the communication apparatus determines a size of a mask matrix (Step S1). In this description, it is assumed, as an example, that the mask matrix Z for codes corresponding to encoding rate 1/3 is a matrix of 64 rows × 32 columns, and a mask matrix $Z^A$ for codes corresponding to encoding rate 1/2 is a matrix of 32 rows × 32 columns.

The LDPC encoder 1 calculates a column degree distribution of a mask matrix $Z^A$ with a density evolution method while setting the number of the columns of the mask matrix $Z^A$ to a maximum degree and by using a column degree distribution of $H_D$ given by Equation (5-2) above as a restriction condition (Step S2). Fig. 2-2 is a table of an example degree distribution of the parity check matrix $H_{M(1/2)}$ (=$[Z^A \times H_{QCU} | H_D]$), in which the numerical numbers (fractions) in the boxes of column degrees 14, 4, and 3 represent a column degree distribution of the mask matrix $Z^A$. The box of column degree 2 corresponds to the column degree distribution of $H_D$.

The LDPC encoder 1 calculates a column degree distribution of the mask matrix Z with a density evolution method while setting the number of the columns of the mask matrix Z to a maximum degree and by using a degree distribution of 64 (row index j is 0 to 63) × 64 (column index 1 is 0 to 63) $H_T$ given by Equation (5-1) above and the column degree distribution of the mask matrix $Z^A$ obtained above as a restriction condition (Step S2). Fig. 2-3 is a table of an example column degree distribution of an irregular parity check matrix $H_{M(1/3)}$ (=$[Z \times H_{QC} | H_T]$) for codes corresponding to encoding rate 1/3. The numerical numbers in the boxes of column degrees 28, 8, 4, and 3 (nine columns) represent a column degree distribution of the mask matrix Z. The box of column degree 1 and (41-9)/96 of column degree 3 correspond to the column degree distribution of $H_T$.

Subsequently, the LDPC encoder 1 determines positions of "1s" in a (each of) large-column-degree column (s) in the mask matrix $Z^A$ such that a condition for priority level #1 below is satisfied based on the column degree distribution of the mask matrix $Z^A$ (Step S3). In this example, positions of "1s" in columns (5/64) with column degree 14 are determined. For example, when Z has consecutive "1s", there can be cyclic permutation matrices between the "1s" and vertically-consecutive I(0)s in $H_T$ at four positions. Although these cyclic permutation matrices can form a loop 4, when the condition for priority level #1 below is satisfied, the possibility of occurrence of such a circumstance is eliminated.

-Condition for priority level #1: "1s" in a single column should be apart by two or more rows from one another.

In this case, because the large-column-degree column has a high density of "1", it is not required to satisfy a condition for priority level #2, which will be described later. Consecutive "1s" can be included in a single column to attain the column degree 14 obtained above; however, the number of the consecutive "1s" is desirably as small as possible.

In this example, there is only one large-column-degree column, i.e., 14. However, when there are a plurality of large-column-degree columns, for example, 14, 13, 12, ···, the columns are arranged in the mask matrix $Z^A$ in a descending order of column degree from left (Step S3).

Subsequently, the LDPC encoder 1 determines positions of "1s" in a (each of) small-column-degree column (s) in the mask matrix $Z^A$ such that the condition for priority level #1 above and the condition for priority level #2 below are satisfied based on the column degree distribution of the mask matrix $Z^A$ (Step S4). In this example, positions of "1s" in columns (18/64 and 9/64) with column degrees 4 and 3 are determined. For example, if "1s" in a mask matrix are arranged to form a specific loop in a condition in which "1s" in the mask matrix are regularly arranged while cyclic permutation matrices are combined based on a regular rule, there can be a large number of identical loops in a multiplexed manner due to the regularity. However, the possibility of occurrence of such a circumstance can be decreased when the condition for priority level #2 below is satisfied.

-Condition for priority level #2: positioning is to be performed based on a random basis.

Columns of the mask matrix $Z^A$ are arranged in a descending order of column degrees from left to follow the large-column-degree column(s) (Step S4).

For example, the mask matrix $Z^A$ generated through Steps S3 and S4 is shown as Equation (14) below.

[Numerical Expression 8]

$$
Z^A =
\begin{bmatrix}
1 & 0 & 0 & 1 & 0 & 0 & 0 & 0 & 0 & 0 & 0 & 1 & 0 & 0 & 0 & 0 & 1 & 0 & 0 & 0 & 0 & 0 & 0 & 0 & 0 & 0 & 0 & 1 & 0 & 0 & 0 & 0 & 0 & 0 \\
0 & 1 & 0 & 0 & 1 & 0 & 0 & 1 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & 1 & 0 & 0 & 0 \\
1 & 0 & 1 & 0 & 0 & 1 & 0 & 0 & 0 & 0 & 0 & 0 & 0 & 0 & 1 & 0 & 0 & 0 & 0 & 1 & 0 & 0 & 0 & 0 & 0 & 0 & 0 & 0 & 0 & 0 & 0 & 0 & 1 & 0 \\
1 & 0 & 0 & 1 & 0 & 0 & 1 & 0 & 0 & 0 & 0 & 0 & 0 & 0 & 0 & 0 & 0 & 0 & 1 & 0 & 0 & 0 & 0 & 0 & 1 & 0 & 1 & 0 & 0 & 0 & 0 & 0 & 0 & 0 \\
0 & 1 & 0 & 1 & 1 & 0 & 0 & 0 & 0 & 0 & 0 & 1 & 0 & 0 & 0 & 0 & 0 & 0 & 0 & 0 & 0 & 1 & 0 & 0 & 0 & 0 & 1 & 0 & 0 & 0 & 0 & 0 & 0 & 0 \\
0 & 0 & 1 & 0 & 1 & 0 & 0 & 0 & 0 & 0 & 1 & 0 & 0 & 0 & 0 & 0 & 0 & 1 & 0 & 0 & 0 & 0 & 1 & 0 & 0 & 0 & 0 & 0 & 0 & 0 & 0 & 0 & 0 & 0 \\
1 & 0 & 0 & 0 & 1 & 0 & 0 & 0 & 0 & 0 & 0 & 0 & 1 & 0 & 0 & 0 & 1 & 0 & 0 & 1 & 0 & 0 & 0 & 0 & 0 & 0 & 0 & 0 & 0 & 1 & 0 & 0 & 0 & 0 \\
1 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 1 & 0 & 0 & 1 & 0 & 0 & 0 \\
0 & 0 & 1 & 1 & 0 & 0 & 0 & 0 & 1 & 0 & 0 & 0 & 0 & 0 & 0 & 1 & 0 & 0 & 0 & 0 & 0 & 0 & 0 & 1 & 0 & 0 & 0 & 0 & 0 & 0 & 0 & 0 & 0 & 0 \\
1 & 0 & 1 & 1 & 1 & 0 & 0 & 0 & 0 & 0 & 0 & 1 & 0 & 0 & 0 & 0 & 1 & 1 & 0 & 0 & 0 & 0 & 0 & 0 & 0 & 0 & 0 & 0 & 0 & 0 & 0 & 0 & 1 & 0 \\
1 & 1 & 0 & 0 & 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 1 & 0 & 0 & 0 & 0 \\
0 & 0 & 1 & 1 & 0 & 0 & 0 & 0 & 0 & 0 & 0 & 0 & 0 & 1 & 0 & 0 & 0 & 0 & 0 & 0 & 0 & 1 & 1 & 0 & 0 & 0 & 0 & 0 & 0 & 0 & 0 & 0 & 0 & 0 \\
1 & 0 & 0 & 1 & 0 & 0 & 0 & 0 & 1 & 0 & 0 & 0 & 0 & 0 & 0 & 0 & 1 & 0 & 0 & 0 & 1 & 0 & 0 & 0 & 1 & 0 & 0 & 0 & 0 & 0 & 0 & 0 & 0 & 0 \\
0 & 1 & 0 & 1 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 1 & 0 & 0 & 0 & 0 & 0 \\
0 & 0 & 1 & 1 & 1 & 0 & 0 & 0 & 0 & 0 & 0 & 0 & 0 & 1 & 0 & 1 & 0 & 0 & 0 & 0 & 0 & 0 & 0 & 0 & 0 & 0 & 0 & 0 & 0 & 0 & 0 & 0 & 0 & 0 \\
1 & 0 & 1 & 0 & 0 & 1 & 0 & 1 & 0 & 0 & 0 & 0 & 0 & 0 & 0 & 0 & 0 & 0 & 0 & 1 & 0 & 0 & 0 & 0 & 1 & 0 & 0 & 0 & 0 & 0 & 0 & 0 & 0 & 0 \\
0 & 1 & 0 & 1 & 0 & 0 & 0 & 0 & 0 & 1 & 0 & 0 & 1 & 0 & 0 & 0 & 0 & 0 & 0 & 0 & 0 & 0 & 0 & 1 & 0 & 0 & 0 & 0 & 0 & 0 & 0 & 0 & 0 & 1 \\
0 & 0 & 1 & 1 & 0 & 0 & 0 & 0 & 0 & 0 & 0 & 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 \\
1 & 0 & 0 & 0 & 1 & 1 & 0 & 0 & 0 & 0 & 1 & 0 & 0 & 0 & 0 & 0 & 0 & 0 & 1 & 0 & 0 & 0 & 0 & 0 & 0 & 1 & 0 & 0 & 0 & 0 & 0 & 0 & 0 & 0 \\
0 & 1 & 0 & 1 & 0 & 0 & 0 & 0 & 0 & 1 & 0 & 0 & 0 & 0 & 0 & 1 & 0 & 0 & 0 & 0 & 0 & 0 & 0 & 0 & 0 & 0 & 0 & 0 & 0 & 0 & 0 & 1 & 0 & 0 \\
0 & 1 & 1 & 0 & 0 & 0 & 0 & 0 & 0 & 0 & 0 & 0 & 0 & 0 & 1 & 0 & 0 & 0 & 0 & 0 & 1 & 0 & 0 & 0 & 1 & 0 & 0 & 0 & 0 & 0 & 0 & 0 & 0 & 0 \\
1 & 0 & 0 & 1 & 0 & 0 & 0 & 0 & 0 & 0 & 0 & 0 & 0 & 1 & 0 & 0 & 0 & 0 & 1 & 0 & 0 & 0 & 0 & 0 & 0 & 0 & 0 & 0 & 1 & 0 & 0 & 0 & 0 & 0 \\
0 & 1 & 0 & 0 & 1 & 0 & 0 & 0 & 0 & 0 & 0 & 0 & 0 & 0 & 0 & 0 & 0 & 1 & 0 & 0 & 0 & 0 & 0 & 1 & 0 & 0 & 0 & 0 & 0 & 0 & 0 & 0 & 0 & 0 \\
0 & 0 & 1 & 1 & 1 & 0 & 0 & 0 & 0 & 0 & 0 & 0 & 0 & 0 & 0 & 0 & 0 & 0 & 0 & 0 & 1 & 0 & 0 & 1 & 0 & 0 & 0 & 0 & 0 & 0 & 0 & 0 & 0 & 0 \\
1 & 0 & 0 & 0 & 0 & 0 & 0 & 0 & 1 & 1 & 0 & 1 & 0 & 0 & 0 & 0 & 0 & 0 & 0 & 0 & 0 & 0 & 0 & 0 & 1 & 0 & 0 & 0 & 0 & 0 & 0 & 0 & 0 & 0 \\
0 & 1 & 0 & 1 & 0 & 0 & 0 & 1 & 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\
0 & 0 & 1 & 0 & 1 & 0 & 0 & 0 & 0 & 0 & 0 & 0 & 0 & 1 & 0 & 1 & 0 & 0 & 0 & 0 & 0 & 0 & 0 & 0 & 0 & 0 & 0 & 0 & 0 & 0 & 0 & 0 & 0 & 1 \\
1 & 0 & 0 & 1 & 0 & 0 & 0 & 0 & 0 & 0 & 0 & 1 & 0 & 0 & 0 & 0 & 0 & 0 & 0 & 0 & 1 & 0 & 0 & 0 & 0 & 0 & 1 & 0 & 0 & 0 & 0 & 0 & 0 & 0 \\
0 & 1 & 0 & 1 & 0 & 0 & 1 & 0 & 0 & 0 & 0 & 0 & 0 & 0 & 0 & 0 & 1 & 0 & 0 & 0 & 0 & 0 & 0 & 1 & 0 & 0 & 1 & 0 & 0 & 0 & 0 & 0 & 0 & 0 \\
0 & 0 & 1 & 0 & 0 & 0 & 0 & 0 & 1 & 0 & 0 & 0 & 0 & 0 & 0 & 0 & 0 & 0 & 0 & 1 & 0 & 0 & 0 & 0 & 0 & 0 & 0 & 0 & 0 & 0 & 0 & 0 & 0 & 0 \\
1 & 1 & 0 & 0 & 1 & 0 & 0 & 1 & 1 & 0 & 0 & 0 & 1 & 0 & 0 & 0 & 0 & 0 & 0 & 0 & 0 & 0 & 0 & 1 & 0 & 0 & 0 & 0 & 0 & 0 & 0 & 0 & 0 & 0 \\
0 & 1 & 0 & 0 & 1 & 1 & 0 & 0 & 0 & 0 & 1 & 0 & 0 & 0 & 0 & 0 & 0 & 0 & 1 & 0 & 0 & 0 & 1 & 0 & 0 & 0 & 0 & 0 & 0 & 0 & 0 & 0 & 0 & 1 \\
\end{bmatrix}
$$

··· (14)

When the mask matrix $Z^A$ is to be generated based on a column degree distribution obtained with a density evolution method, if the mask matrix $Z^A$ includes a small loop (e.g., loop 4 or 6) at a small-column-degree column (with, e.g., column degree 3 or 4), an error probability increases. This can result in failure in exhibiting excellent performance. In such a case, the LDPC encoder 1 increases weights of small-column-degree columns to avoid performance degradation. In the mask matrix $Z^A$ above, weights of three columns among columns (9/64) with column degree 3 in the column degree distribution shown in Fig. 2-2 are increased. More specifically, Equation (14) contains 5 columns with column degree 14, 21 columns with column degree 4, and 6 columns with column degree 3.

Subsequently, the LDPC encoder 1 determines positions of "1s" in a (each of) large-column-degree column (s) in the mask matrix Z such that the condition for priority level #1 above is satisfied based on the column degree distribution of the mask matrix Z (Step S5). In this example, positions of "1s" in column (5/96) with column degree 28 are determined. Note that because the large-column-degree column has a high density of "1", it is not required to satisfy the condition for priority level #2. Consecutive "1s" can be included in a single column to attain the column degree 28 obtained above; however, the number of the consecutive "1s" is desirably as small as possible.

In this example, there is only one large-column-degree column, i.e., 28; however, when there are a plurality of large-column-degree columns, columns of the mask matrix Z are to be arranged in a descending order of column degree from left (Step S5).

Subsequently, the LDPC encoder 1 determines positions of "1s" in a (each of) small-column-degree column (s) in the mask matrix Z such that the condition for priority level #1 above and the condition for priority level #2 above are satisfied based on the column degree distribution of the mask matrix Z (Step S6). In this example, positions of "1s" in columns with column degrees 8 and 4 and some of columns with column degree 3 (10/96, 8/96, and 9/96) are determined.

Columns of the mask matrix Z are arranged in a descending order of column degrees from left to follow the large-column-degree column(s) (Step S6).

When the mask matrix Z is to be configured based on a column degree distribution obtained with a density evolution method, if the mask matrix Z includes a small loop (e.g., loop 4 or 6) at a small-column-degree column (with, e.g., column degree 3, 4, or 8), an error probability increases. This can result in failure in exhibiting excellent performance. In such a case, the LDPC encoder 1 increases weights of small-column-degree columns to avoid performance degradation.

When LDPC codes are used in an application such as m-ary modulation that has a non-uniform error probability, performance will be improved by assigning bits having small error probability to bits corresponding to a large-column-degree column and bits having large error probability to bits corresponding to a small-column-degree column. In such a case, arranging the columns in the descending order of column degrees from left as described above with reference to Steps S3 to S6 facilitates ordering of bits.

Fig. 2-4 is a schematic diagram illustrating a configuration example of an irregular parity check matrix $H_{M(1/2)}$ having been masked with the mask matrix $Z^A$ generated as described above. Fig. 2-5 is a schematic diagram illustrating a configuration example of an irregular parity check matrix $H_{M(1/3)}$ having been masked with the mask matrix Z generated as described above. In Fig. 2-5, $H_{QCD}$ in the drawing is a quasi-cyclic matrix with 32 (row index j: 32 to 63) $\times$ 32 (column index 1 is 0 to 31), which is a lower half of the quasi-cyclic matrix $H_{QC}$. Meanwhile, in the drawing, 0 represents a zero matrix and I represents a unit matrix. $H_T$ is formed of $H_D$, Is, and 0.

Next, a method of enabling encoding with encoding rate equal to or higher than 3/7 based on the processing for generating codes of encoding rate 1/3 will be described. A portion of the mask-matrix generation processing according to the present embodiment that differs from the processing for generating codes of encoding rate 1/3 will be described. In the present embodiment, as will be described later, it is assumed that a check matrix corresponding to encoding rate 3/4 will be generated first; however, the check matrix generated first is not limited thereto. Any check matrix corresponding to encoding rate equal to or lower than 1/2 can be generated first.

For example, assume that an irregular parity check matrix for codes of encoding rate 3/4 is assumed as "$H_{M(3/4)}$= $[Z^A \times H_{QC(3/4)}|H_{T(3/4)}]$". $Z^A$ ($=Z^{A(3/4)}$) is a mask matrix of 12 rows $\times$ 36 columns. $H_{QC(3/4)}$ is a quasi-cyclic matrix of 12 rows (row number j is 0 to 11) $\times$ 36 columns (column number 1 is 0 to 35), which a top quarter of the quasi-cyclic matrix $H_{QC}$ (see Equation (4-1)). $H_{T(3/4)}$ is $H_D$ having been described above (see Equation (5-2)). For encoding rate 3/5, 3/6=1/2, and 3/7, irregular parity check matrices are denoted as $H_{M(3/5)}$, $H_{M(1/2)}$, and $H_{M(3/7)}$ ($=H_M$), respectively; mask matrices are denoted as $Z^{A(3/5)}$, $Z^{A(1/2)}$, and $Z^{A(3/7)}$ ($=Z$), respectively; quasi-cyclic matrices are denoted as $H_{QC(3/5)}$, $H_{QC(1/2)}$, and $H_{QC(3/7)}$ ($=H_{QC}$), respectively; and matrices in which I(0)s are arranged in a staircase manner are denoted as $H_{T(3/5)}$, $H_{T(1/2)}$, and $H_{T(3/7)}$ ($=H_T$), respectively.

For example, as processing to be performed at Step S2 of Fig. 2-1, the LDPC encoder 1 of the present embodiment first sets the number of the rows of the mask matrix $Z^A$ for encoding rate 3/4 to the maximum degree, and calculates column degree distribution of the mask matrix $Z^A$ with a density evolution method by using degree distribution of $H_{T(3/7)}$ ($=T_D$) as a restriction condition. Next, the LDPC encoder 1 calculates, for encoding rate 3/5, column degree distribution of the mask matrix $Z^{A(3/5)}$ with a density evolution method by using the degree distribution of $H_{T(3/5)}$ and the column degree distribution of the calculated mask matrix $Z^A$ as a restriction condition. Next, the LDPC encoder 1 sequentially calculates column degree distributions of the mask matrices with a density evolution method by using column degree distribution of an immediately preceding mask matrix as a restriction condition. Finally, column degree distribution of the mask matrix Z corresponding to encoding rate 3/7 is calculated with a density evolution method by using the degree distribution of $H_T$ and the column degree distribution $Z^{A(3/6)}$ for encoding rate 3/6 as a restriction condition.

Subsequently, as processing to be performed at Steps S3 to S6 of Fig. 2-1, as with the first embodiment, the LDPC encoder 1 determines positions of "1s" in each of columns of the mask matrix corresponding to encoding rate 3/4 and that corresponding to encoding rate 3/5 based on the condition for priority level #1 and the condition for priority level #2. Thereafter, the LDPC encoder 1 determines positions of "1s" in each of columns of the mask matrix corresponding to encoding rate 3/6 and that corresponding to encoding rate 3/7 in a similar procedure. The mask matrix Z generated by the processes according to the present embodiment can be expressed as Equations (12-1) to (12-5).

Fig. 3 is a schematic diagram illustrating a configuration example of an irregular parity check matrix $H_M$ after being masked by the mask matrix Z generated as described above.

Next, the case in which the LDPC codes corresponding to the encoding rates are configured using the irregular parity check matrix $H_M$ will be explained below.

The lower limit of the encoding rate of the code generated by, for example, the code configuration method and defined by M and N is set to any value from 1/2 to 1/3. To attain encoding rate equal to or lower than the lower limit, it is desirable to perform repeated transmission, which will be described later, for excellent performance.

Fig. 4 is a schematic diagram illustrating an example of the code configuration method according to the present embodiment, wherein for example, codes of the encoding rate 0.75 are defined as a reference code, and parity is punctured in generating a code of an encoding rate (=0.9) higher than that. Incidentally, for decoding at this time, it is only necessary to insert zero in a received LLR corresponding to puncturing bits using the check matrix of the encoding rate 3/4 to then perform a normal LDPC decoding. Meanwhile, parity is added in generating a code of an encoding rate (=3/5) lower than that. Decoding at this time is performed by using only the submatrices of the check matrix $H_M$ corresponding to the encoding rate, as shown in Fig. 3.

A configuration method of the LDPC codes corresponding to the encoding rates will be specifically explained here. For example, it is supposed that the lowest encoding rate prepared by the system is $R_0=1/2$ or less. Fig. 5 is a schematic diagram illustrating codes when the lowest encoding rate prepared by the system is, for example, $R_0=3/7$.

For example, when the codes corresponding to the encoding rate $R_0=3/7$ are stored in the memory to form codes of an encoding rate $R_1$, and if the encoding rate $R_1$ is less than 3/4, namely, if the encoding rate $R_1$ is any value between 3/4 to 3/7, the parity bits are punctured from the end of the code in order.

Meanwhile, for example, if an encoding rate of 3/7 or less is required, code bits B (length b: information for bits corresponding to each column is the same as A) selected in order of decreasing the column weight are added to a code (A + parity bits in Fig. 6) of an encoding rate K/N=3/7 based on the data length K and the code length N as shown in Fig. 6 in the present embodiment, to generate the code of an encoding rate K/(N+b). For example, if b=(2/3)*K, the encoding rate becomes 1/3, while if b=K, the encoding rate becomes 3/10. Fig. 6 is a schematic diagram illustrating the code configuration method according to the present embodiment when an encoding rate of 3/7 or less is required.

It is also allowed to repeatedly transmit code bits of "A+parity bits+B" again when a part of identical codes is transmitted twice in a repeated manner as with b=(2/3)*K (B portions in Fig. 7) and a further lower encoding rate is required. This is because it is verified that repeated transmission of the portion B, which is a heavy-column-weight portion, improves performance. A still further lower encoding rate can be attained by transmitting this portion ("A+parity bits+B") further repeatedly.

The code encoded by the method is then received by the reception apparatus through the communication channel, and if parts of or all of the code overlap when the decoder corrects an error, received values of the overlapped bits are added by the number of the overlapped portions and are averaged, to then transfer the result to the decoder. Moreover, it is known that the decoding performance becomes better when the code bits correspond to a column with a high weight. Thus, in the present embodiment, the variance of noise component can be reduced by the processing, and the reliability thereby increases (the error rate of the corresponding bits decreases), and thus improving the decoding performance.

Incidentally, it is described in the present embodiment that p of the cyclic permutation matrices is an odd prime number (other than 2), however, p is not limited thereto, and thus any odd number may be selected. In this case, although the performance may be degraded upon puncture of the high encoding rate, the degradation is only a slight amount. Meanwhile, if a prime number is used, it is necessary to obtain a table of prime numbers and previously store them therein to avoid an increase in the amount of calculations, however, if an odd number is used, the value does not need to be stored.

As described above, according to the present embodiment, in contrast to the conventional technology, it is not required to store a plurality of totally different check matrices for different encoding rates is not required. Accordingly, because a memory that is smaller in memory amount than the conventional memory can be used, circuit can be simplified.

In the present embodiment, a check matrix is extended on a base of, for example, a check matrix corresponding to encoding rate 3/4, which is a check matrix smaller than a check matrix corresponding to encoding rate 1/2, while decoding for encoding rate equal to or lower than 3/4 is performed according to the check matrix corresponding to encoding rate 3/4. Accordingly, an amount of calculations required for decoding can be reduced as compared with a case in which decoding is performed on a base of the check matrix corresponding to encoding rate 1/2. Even an encoding rate, such as encoding rate equal to or lower than 3/7, can be attained by increasing the number of repeated transmissions of a code of a heavy column degree portion. Hence, according to the present embodiment, a wider ratio of encoding rate can be attained while preventing performance degradation.

Second Embodiment

In the first embodiment, the example in which the cyclic permutation matrix $I(p_{j,l})$ is configured in accordance with a certain rule has been described. In contrast, in the present embodiment, encoding rate 3/7 is attained by using, for example, a generally-available matrix for encoding rate 3/4 as shown in Fig. 8 (Draft IEEE Standard for local and metropolitan area networks, Part 16: Air Interface for Fixed and Mobile Broadband Wireless Access Systems, Amendment for Physical and Medium Access Control Layers for Combined Fixed and Mobile Operation in Licensed Bands", IEEE P802.16e/D9, June 2005). Numerical numbers in Fig. 8 are values of $p_{j,l}$, and -1 is a zero matrix of pxp.

More specifically, when $H_{CH}$ is assumed as an M×N matrix for encoding rate 3/4 formed of the matrix shown in Fig. 8, a 4Mx(7/3)N matrix $H_{CH}'$ is configured as shown in Fig. 9. For example, A is a matrix configured based on an arbitrary combination of cyclic permutation matrices. Furthermore, pairs of unit matrices, in which each pair includes two unit matrices coupled together, are arranged so as to form a staircase descending to the right. Weight distribution of the matrix A is calculated with a density evolution method. The parity check matrix for LDPC can be generated as with the first embodiment by using this method.

It is noted that the matrix A may be configured with matrices based on an arbitrary combination of the cyclic permutation matrices as shown in the present embodiment, or may be configured based on the regular rule as shown in the first embodiment. The processing of forming the LDPC codes corresponding to the encoding rates is not limited to the parity check matrix as shown in Fig. 8, but is applicable to any type of parity check matrix.

For example, when $H_{CH}$ is assumed as an Mx(N-M) matrix configured based on an arbitrary combination of cyclic permutation matrices, a 4Mx(7/3)N matrix $H_{CH}$' is configured as shown in Fig. 10. A is a matrix configured based on an arbitrary combination of cyclic permutation matrices. $H_D$ is arranged on the right of $H_{CH}$ and A. Weight distribution of the matrix A is calculated with a density evolution method. The parity check matrix for LDPC can be generated as with the first embodiment by using this method.

Note that the code configuration method and the encoding method according to the first embodiment and the second embodiment are applicable to encoding of erasure correction codes.

INDUSTRIAL APPLICABILITY

As described above, the check-matrix generating method and encoding method according to the present invention are useful as the encoding technology in digital communications, and are particularly suitable for the communication apparatuses that employ the LDPC codes as the encoding system.

**Claims**

1. A check-matrix generating method of generating a parity check matrix for an LDPC (Low-Density Parity Check) code, the check-matrix generating method comprising:

    a quasi-cyclic matrix generating step of generating a regular (weights of a row and a column are uniform) quasi-cyclic matrix in which cyclic permutation matrices are arranged in a row direction and a column direction and specific regularity is given to the cyclic permutation matrices;
    a mask-matrix generating step of generating a mask matrix capable of supporting a plurality of encoding rates, for making the regular quasi-cyclic matrix into irregular (weights of a row and a column are nonuniform);
    a masking step of converting a specific cyclic permutation matrix in the regular quasi-cyclic matrix into a zero-matrix using a mask matrix corresponding to a specific encoding rate to generate an irregular masking quasi-cyclic matrix; and
    a check-matrix generating step of generating an irregular parity check matrix with an LDGM (low-density generation matrix) structure in which the masking quasi-cyclic matrix and a matrix in which the cyclic permutation matrices are arranged in a staircase manner are arranged in a predetermined location, wherein
    the mask-matrix generating step includes
    a degree distribution calculating step of sequentially calculating a column degree distribution of a first mask matrix corresponding to an encoding rate (first encoding rate) equal to or lower than 1/2 serving as a reference, a column degree distribution of a second mask corresponding to a second encoding rate that is an encoding rate next lower than the first encoding rate by using the column degree distribution of the first mask matrix as a restriction condition, and, as required, a column degree distribution of a third mask matrix, a column degree distribution of a fourth mask matrix, ···, each by using a column degree distribution of an immediately preceding mask matrix as a restriction condition, and
    a weight-position determining step of determining weight positions in columns of each of the mask matrices in order from the first mask matrix having a highest encoding rate based on the column degree distribution of the mask matrix, and
    the check-matrix generating step includes generating a check matrix corresponding to the encoding rate equal to or lower than 1/2 first.

2. The check-matrix generating method according to claim 1, wherein the check-matrix generating step further includes generating a check matrix corresponding to encoding rate lower than 1/3 last.

3. The check-matrix generating method according to claim 2, wherein the weight-position determining step includes generating the mask matrix by classifying each of the columns as any one of a large-column-degree column and a small-column-degree column based on a probability of error occurrence resulting from a low column degree, and determining weight positions in the small-column-degree column such that a first condition that weights in a single column are apart from one another with two or more rows therebetween and a second condition that weights are arranged on a random basis are satisfied.

**4.** The check-matrix generating method according to claim 3, wherein the weight-position determining step further includes, such that the second condition is satisfied,

generating a random number sequence by a predetermined method,

generating, when the random number sequence includes one element and another element in which a difference between the one element and the other element is one, a pseudo-random number sequence in which a difference between the one element and the other element is equal to two or greater by moving the one element to a trailing end of the random number sequence, and

dividing the pseudo-random number sequence on a column-degree-by-column degree basis and assuming each of the divided sequences as row position numbers in each column weight.

**5.** The check-matrix generating method according to claim 3, wherein the weight-position determining step further includes arranging the columns in the mask matrix in a descending order of column degree in the column degree distribution.

**6.** The check-matrix generating method according to claim 4, wherein the weight-position determining step further includes arranging the columns in the mask matrix in a descending order of column degree in the column degree distribution.

**7.** An encoding method of encoding predetermined data bits by using a parity check matrix for LDPC (Low-Density Parity Check) codes, the encoding method comprising an encoding step of encoding the predetermined data bits by using the irregular parity check matrix generated by a processing according to claim 2.

**8.** The encoding method according to claim 7, wherein the encoding step includes adding, to a code having a data length K and a code length N (data bits A + parity bits P) of encoding rate K/N+b, code bits B (bit length b) that are sequentially selected from the data bits A in a descending order of column weight, thereby generating a code "A+P+B" of encoding rate K/(N+b).

**9.** The encoding method according to claim 8, wherein
the encoding rate K is 3/7, and
the encoding rate K/(N+b) is 1/3.

**10.** The encoding method according to claim 9, wherein when a still lower encoding rate is required, the encoding step further includes generating code bits by repeating the "A+P+B".

**11.** A communication apparatus that generates a parity check matrix for LDPC (Low-Density Parity Check) codes, wherein the communication apparatus generates an irregular parity check matrix with an LDGM (Low Density Generation Matrix) structure by a processing according to claim 2.

**12.** A communication system that employs LDPC (Low-Density Parity Check) codes as an error correction technology, the communication system comprising:

a transmission apparatus that encodes predetermined data bits by a processing according to claim 7; and
a reception apparatus that decodes a code by a known processing.

**13.** An encoder that encodes predetermined data bits by using a parity check matrix for LDPC (Low-Density Parity Check) codes, the encoder comprising an encoding unit that encodes the predetermined data bits by using the irregular parity check matrix generated by a processing according to claim 7.

# FIG.1

# FIG.2-1

START

SET SIZE OF MASK MATRIX TO MULTIPLE OF EIGHT — S1

OBTAIN DEGREE DISTRIBUTIONS OF $Z^A$ AND $Z$ — S2

DETERMINE POSITIONS OF "1"s IN COLUMN THAT IS CLASSIFIED AS LARGE-COLUMN-DEGREE COLUMN IN MASK MATRIX $Z_A$ SO AS TO SATISFY CONDITION FOR PRIORITY LEVEL #1 — S3

DETERMINE POSITIONS OF "1"s IN COLUMN THAT IS CLASSIFIED AS SMALL-COLUMN-DEGREE COLUMN IN MASK MATRIX $Z_A$ SO AS TO SATISFY CONDITIONS FOR PRIORITY LEVEL #1 AND PRIORITY LEVEL #2 — S4

DETERMINE POSITIONS OF "1"s IN COLUMN THAT IS CLASSIFIED AS LARGE-COLUMN-DEGREE COLUMN IN MASK MATRIX $Z$ SO AS TO SATISFY CONDITION FOR PRIORITY LEVEL #1 — S5

DETERMINE POSITIONS OF "1"s IN COLUMN THAT IS CLASSIFIED AS SMALL-COLUMN-DEGREE COLUMN IN MASK MATRIX $Z$ SO AS TO SATISFY CONDITIONS FOR PRIORITY LEVEL #1 AND PRIORITY LEVEL #2 — S6

END

# FIG.2-2

| | COLUMN DEGREE | | | | DIFFERENCE TO SHANNON LIMIT (dB) |
|---|---|---|---|---|---|
| | 14 | 4 | 3 | 2 | |
| DEGREE DISTRIBUTION OF $H_{M(1/2)}$ | 5/64 | 18/64 | 9/64 | 32/64 | 0.546 |

# FIG.2-3

| COLUMN DEGREE RATIO (FIXED) OF $H_{M(1/2)}$ | COLUMN DEGREE OF $H_{M(1/2)}$ | | | | | |
|---|---|---|---|---|---|---|
| | 14 | 4 | 3 | 2 | | |
| | 5/64 | 18/64 | 9/64 | 32/64 | | |

| | COLUMN DEGREE OF $H_M$ | | | | | DIFFERENCE TO SHANNON LIMIT (dB) |
|---|---|---|---|---|---|---|
| | 28 | 8 | 4 | 3 | 1 | |
| DEGREE DISTRIBUTION OF $H_{M(1/3)}$ | 5/96 | 10/96 | 8/96 | 41/96 | 32/96 | 0.486 |

# FIG.2-4

$$Z^A \otimes H_{QCU} \qquad H_D$$

COLUMN DEGREE 14

COLUMN DEGREE 4

COLUMN DEGREE 3

COLUMN DEGREE 2

# FIG.2-5

$$[Z^A(1:32,2:5)Z^A(1:32,1)Z^A(1:32,7:16)\ 0_{32\times17}] \otimes H_{QCD}$$

$$Z^A \otimes H_{QCU} \qquad H_D \qquad 0$$

$$I \qquad I$$

COLUMN DEGREE 28

COLUMN DEGREE 8

COLUMN DEGREE 4

COLUMN DEGREE 3

COLUMN DEGREE 3

COLUMN DEGREE 1

# FIG.3

COLUMNS CORRESPONDING
TO PARITY BITS OF
ENCODING RATE 1/2

COLUMNS CORRESPONDING TO
PARITY BITS OF ENCODING RATE 3/5

COLUMNS
CORRESPONDING TO
PARITY BITS OF
ENCODING RATE 3/7

COLUMNS CORRESPONDING TO
PARITY BITS OF ENCODING RATE 3/4

COLUMNS CORRESPONDING
TO INFORMATION BITS

ROWS CORRESPONDING
TO ENCODING RATE 3/4

ROWS CORRESPONDING
TO ENCODING RATE 3/5

ROWS CORRESPONDING
TO ENCODING RATE 1/2

ROWS CORRESPONDING
TO ENCODING RATE 3/7

$Z \otimes H_{QC}$

$H_D$

$I$  $I$

$I$  $I$

$I$  $I$

COLUMN
DEGREE 3

COLUMN
DEGREE 2

COLUMN
DEGREE 1

EP 2 053 751 A1

# FIG.4

ENCODING RATE 0.75 | DATA BITS | PARITY BITS |

ENCODING RATE 0.9 | DATA BITS | | | | | |

PUNCTURE BITS

ENCODING RATE 0.6 | DATA BITS | PARITY BITS | PARITY BITS |

# FIG.5

ENCODING RATE 3/7, AND THE LIKE

| DATA | | PARITY | PUNCTURE |

# FIG.6

ACTUAL
TRANSMISSION ⟶
SEQUENCE

| A | PARITY BITS | B |

⇧

DATA BITS ⟨ B
A | PARITY BITS

⇧        ⇧

$Z \otimes H_{QC}$ | $H_D$
| $I$ | $I$
| | $I$ | $I$
| | | $I$ | $I$

HEAVY COLUMN
DEGREE

COLUMN
DEGREE
3

COLUMN
DEGREE
2

COLUMN
DEGREE
1

# FIG.7

ACTUAL
TRANSMISSION ⟶
SEQUENCE

| A | PARITY BITS | B | A | PARITY BITS | B |

# FIG.8

RATE 3/4 A CODEC

```
 6  38   3  93  -1  -1  -1  30  70  -1  86  -1  37  38   4  11  -1  46  48   0  -1  -1  -1  -1
62  94  19  84  -1  92  78  -1  15  -1  -1  92  -1  45  24  32  30  -1  -1   0   0  -1  -1  -1
71  -1  55  -1  12  66  45  79  -1  78  -1  -1  10  -1  22  55  70  82  -1  -1   0   0  -1  -1
38  61  -1  66   9  73  47  64  -1  39  61  43  -1  -1  -1  -1  95  32   0  -1  -1   0   0  -1
-1  -1  -1  -1  32  52  55  80  95  22   6  51  24  90  44  20  -1  -1  -1  -1  -1  -1   0   0
-1  63  31  88  20  -1  -1  -1   6  40  56  16  71  53  -1  -1  27  26  48  -1  -1  -1  -1   0
```

# FIG.9

# FIG.10

# FIG.11

# FIG.12

$$H = \begin{bmatrix} 1 & 1 & 0 \\ 1 & 1 & 1 \end{bmatrix}$$

**INTERNATIONAL SEARCH REPORT**

| International application No. |
| --- |
| PCT/JP2007/065195 |

A. CLASSIFICATION OF SUBJECT MATTER
*H03M13/19(2006.01)i*

According to International Patent Classification (IPC) or to both national classification and IPC

B. FIELDS SEARCHED

Minimum documentation searched (classification system followed by classification symbols)
H03M13/19

Documentation searched other than minimum documentation to the extent that such documents are included in the fields searched
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2005-110251 A (Mitsubishi Electric Research Laboratories, Inc.), 21 April, 2005 (21.04.05), Full text; all drawings & US 6771197 B1 | 1-13 |
| A | WO 2006/027897 A1 (Mitsubishi Electric Corp.), 16 March, 2006 (16.03.06), Full text; all drawings & EP 1788709 A1 | 1-13 |

☐ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 29 August, 2007 (29.08.07) | 11 September, 2007 (11.09.07) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. FOSSORIER.** Quasi-Cyclic Low Density Parity Check Code. *ISIT2003,* 29 June 2003, 150